# EUROPEAN PATENT SPECIFICATION

(11) **EP 0 217 150 B1**
(45) Date of publication and mention of the grant of the patent: **28.12.1994**
(21) Application number: 86112003.8
(22) Date of filing: 29.08.1986
(51) Int. Cl.: H05K 3/00

(54) **Film peeling apparatus**
Vorrichtung zum Abschälen eines Films
Appareil pour peler une pellicule

(30) Priority: 31.08.1985 JP 192910/85; 31.08.1985 JP 192911/85; 13.12.1985 JP 280796/85; 05.02.1986 JP 23174/86; 05.02.1986 JP 23175/86
(43) Date of publication of application: 08.04.1987
(73) Proprietor: SOMAR CORPORATION, Tokyo 104 (JP)
(72) Inventor: Hamamura, Fumio, Yokohama-shi Kanagawa (JP); Sumi, Shigeo, Hasuda-shi Saitama (JP)
(74) Representative: Boeters, Hans Dietrich, Dr.

(56) References cited:
- EP-A- 0 087 551
- EP-A- 0 142 880
- DE-A- 2 751 862
- DE-A- 3 147 818
- DE-A- 3 339 723
- FR-A- 2 360 499
- JP-A-58 091 782
- JP-A-58 091 782
- US-A- 4 470 589
- PATENT ABSTRACTS OF JAPAN, vol. 9, no. 6 (P-326)[1729], 11th January 1985; & JP-A-59 154 447

## Description

The invention relates to a film peeling apparatus for peeling off a film stuck on a board.

Printed circuit boards for use in electronic equipment such as computers are provided with a predetermined copper wiring pattern formed on one or both sides of insulating boards.

A printed circuit board of that sort is manufactured by the steps comprising laminating a photosensitive resin layer (photoresist) and a translucent resin film (protective film) for protecting the photosensitive resin layer on a conductive layer laid on an insulating substrate through thermocompression bonding; superposing a film having a wiring pattern; exposing the photosensitive resin layer to light for a fixed period of time through the film having the wiring pattern and the translucent resin film; developing the thus exposed photosensitive resin layer after peeling off the translucent resin film to form an etching mask pattern; removing unnecessary portions of the conductive layer by etching; and further removing the remaining photosensitive resin layer. A printed circuit board having a predetermined wiring pattern is thus prepared.

During the above steps of manufacturing a printed circuit board, the translucent resin film must be peeled off when the photosensitive resin layer is developed after being exposed to light. That step of peeling off the translucent resin film still relies on manual work, which requires a clever-fingered worker as well as an extremely skilled hand to prevent damage and breakdown attributed to unevenly distributed peel stress as the film is thin.

The problem is that lengthy work is required in the manufacture of a printed circuit board because it takes time to peel off the translucent resin film.

From JP-A-58 091 782 there is known an apparatus for peeling off a protective paper stuck on a board, comprising needles for applying force to the forward end of the paper and the board, to form a gap between the paper and the board by plastic deformation, further comprising nozzles for blowing compressed air to said end and for thereby enlarging the gap between the paper and the board and further comprising a nipping board for nipping the adhered paper.

It is therefore the main object of this invention to improve the peeling effect of a film peeling apparatus as described in the introductory portion of the description.

This problem is solved by the apparatus defined in claim 1.

Embodiments of the invention and advantages will now be described with reference to the accompaning drawings.

Of the embodiments disclosed by the present invention, a typical one may be outlined as follows.

The peeling apparatus for peeling off films stuck on a board comprises projected press members for applying force to the ends of the films stuck on the board and fluid spray means for sending jets of fluid to the portions to which the force has been applied.

Accordingly, a gap is formed under the end of each film by applying force thereto using the portion to ensure that the film is instantly peeled off.

### BRIEF DESCRIPTION OF THE DRAWINGS

Fig. 1 is a sectional view outlining the construction of a peeling apparatus for peeling off a protective film of a printed circuit board as an embodiment of the present invention;
Fig. 2 is an enlarged sectional view of the projected press mechanism of Fig. 1;
Fig. 3 is an enlarged perspective view of the principal portion of the position setting member of Fig. 1;
Figs. 4 and 5 are enlarged sectional views of the principal portion of Fig. 2;
Fig. 6 is an enlarged sectional view of the fluid spray mechanism and the film discharge mechanism of Fig. 1;
Fig. 7 is a perspective view of the principal portion of the film discharge mechanism of Fig. 6;
Figs. 8 through 10 are perspective views of another projected press member;
Fig. 11 is a perspective view of still another projected press member;
Fig. 12 is a perspective view outlining the construction of another film peeling guide;
Fig. 16 is an enlarged traced side view of the principal portion of a film raising means;
Fig. 17 is a structural drawing of the projected press mechanism of Fig. 16;
Fig. 18 is an expanded exploded view of Fig. 17;
Fig.19 is a partial sectional view of the projected press member of Fig. 18;
Figs. 20 and 21 are sectional views of the principal portions of the printed circuit of Fig. 16; and
Fig. 22 is a perspective view showing a peeling angle setting plate.

### PREFERRED EMBODIMENTS OF THE INVENTION

A description will subsequently be given of a peeling apparatus for peeling off a protective film stuck on a printed circuit board as an embodiment of the present invention.

In the accompanying drawings illustrating the embodiment thereof, like reference characters are given to like component parts having the same functions and the repetition of the description thereof will be omitted.

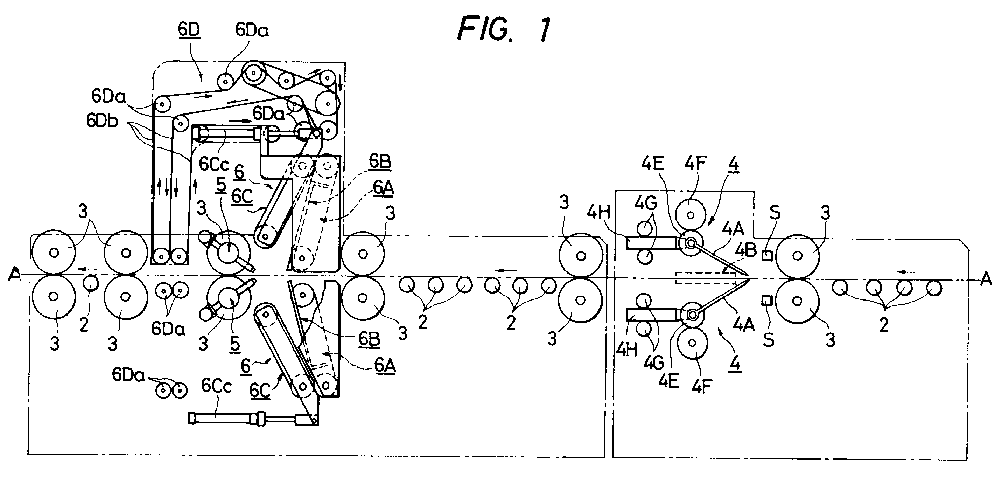

Fig. 1 is a sectional view outlining the construction of a peeling apparatus for peeling off protective films as an embodiment of the present invention.

As shown in Fig. 1, a mechanism for conveying a printed circuit board in the peeling apparatus for peeling off the protective films according to this embodiment comprises conveyor rollers 2 for carrying a printed circuit board 1 and conveyance control rollers 3.

Projected press mechanisms 4, fluid spray mechanisms 5 and film conveyance mechanisms 6 are installed in the conveyance path of the conveyance mechanism.

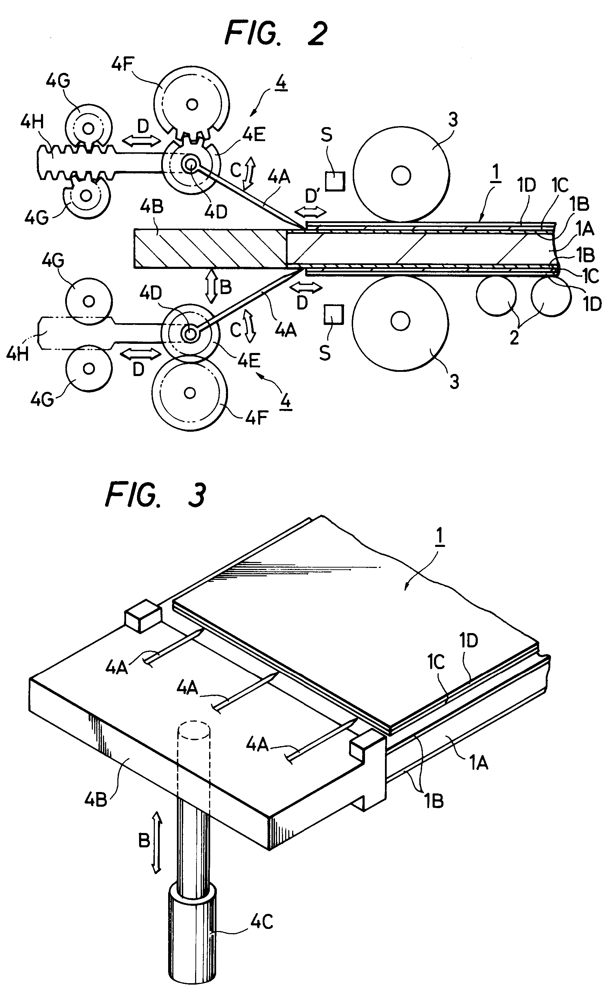

As shown in Fig. 2, the printed circuit board 1 is formed of conductive layers 1B of copper stuck to both sides (or one side) of an insulating substrate 1A. Laminated bodies, each consisting of a photosensitive resin layer 1C and a translucent (protective) resin film 1D, are stuck on the conductive layers 1B of the printed circuit board 1 through thermocompression bonding. The photosensitive resin layers 1C are in such a state that they have been exposed to light so as to form a predetermined patatern.

The conveyor rollers 2 and the conveyance control rollers 3 are so arranged as to carry the printed circuit board 1 in the direction of an arrow in the conveyance path whose view is taken online A-A of Fig. 1.

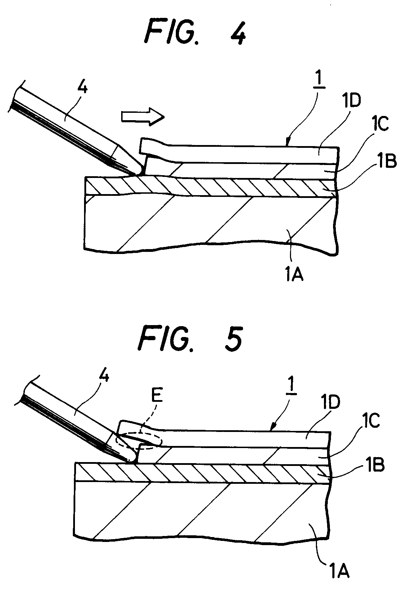

The projected press mechanism 4 shown in Figs. 1, 2 is so arranged as to apply force to the end of the photosensitive resin layer 1C and/or the translucent resin film 1D with a projected needle-shaped press member 4A. More specifically, the front end of the printed circuit board 1 abuts against a position setting member 4B shown in Figs. 1, 2 and 3 when the front end thereof is detected by a position detector S. The position detector S is formed with a photosensor. The position setting member 4B is caused to slide by a driving means 4C such as an air cylinder, solenoid or the like in the direction of an arrow B according to the detection signal of the position detector S. Subsequently, the front end of the projected press member 4A is made to abut onto the end of the conductive layer 1B in the conveyance direction of the photosensitive resin layer 1C and the translucent resin film 1D. The projected press member 4A is made movable by gears 4E, 4F on the axis 4D in the direction of an arrow C. The projected press member 4A is moved in the direction of an arrow D′ (to the right in the drawing) in such a manner as to slide on the conductive layer 1B when a rack 4H is moved in the direction of an arrow D as a gear 4G turns. As shown in Fig. 4, the force is applied to the ends of the photosensitive resin layer 1C and/or the translucent resin film 1D as the projected press member 4A moves. Then the projected press member 4A is moved left (in the drawing) as occasion arises.

A gap between the photosensitive resin layer 1C and the translucent resin film 1D can thus be formed as shown in Fig. 5 by applying force to the ends of the photosensitive resin layer 1C and the translucent resin film 1D of the printed circuit board 1 with the needle-shaped press member 4A. The reason for the formation of such a gap is that, when force is applied to the photosensitive resin layer 1C and the translucent resin film 1D, shear stress will be generated therebetween if they are prepared from different materials and if the former is subject to plastic deformation as compared with the latter.

Moreover, the projected press member 4A installed in the conveyance path of the printed circuit board 1 allows the gap to be formed automatically between the photosensitive resin layer 1C and the translucent resin film 1D.

Although the photosensitive resin layer 1C and the translucent resin film 1D allowing the formation of the gap are pressed by the conveyor rollers 2 or the conveyance control roller 3 while they are being carried into the fluid spray mechanism 5, they will not stick to each other because they have not been heat bonded under pressure.

Three units of projected press members 4A have been installed in the conveyance direction of the printed circuit board 1 for fear of the distorted lamination of the photosensitive resin layers 1C and the translucent resin films 1D through thermocompression bonding according to this embodiment. However, the present invention is not restricted to such an arrangement. In other words, one, two or more than three projected press members 4A may be used to constitute the projected press mechanism 4, provided it is ensured that force is applied to the ends of the photosensitive resin layers 1C and the translucent resin films 1D.

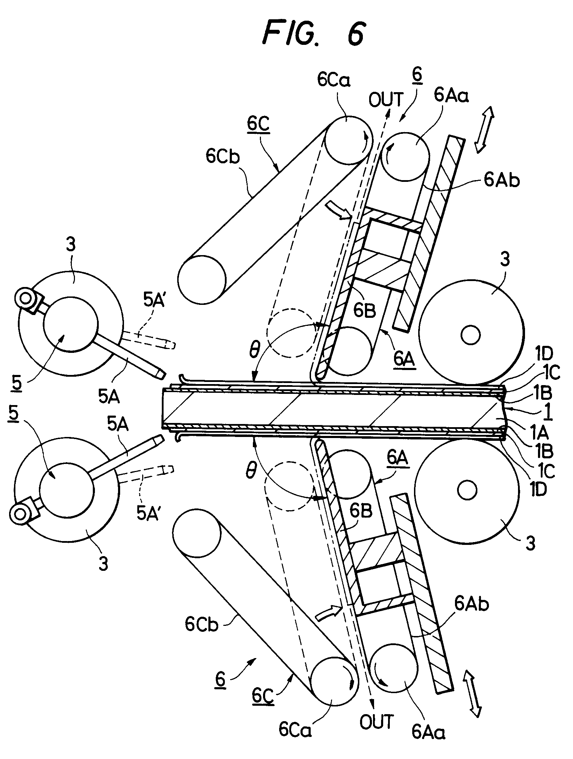

As shown in Figs. 1, 6, the fluid spray mechanisms 5 are so arranged as to send jets of pressurized fluid such as air, inert gas or water out of nozzles 5A. The fluid spray mechanism 5 is used to send a jet of fluid directly to the gap formed between the photosensitive resin layer 1C and the translucent resin film 1D of the printed circuit board 1. The printed circuit board 1 is carried into the predetermined position of the fluid spray mechanisms 5 with the conveyance control rollers 3. The set angle of the nozzle 5A may be made variable as shown by a reference character 5′ of Fig. 6.

Since the fluid spray mechanism 5 sends a jet of fluid to the gap between the photosensitive resin layer 1C and the translucent resin film 1D because of the projected press member 4A, the translucent resin film 1D is peeled off surely, accurately and instantly.

The film discharge mechanism 6 comprises a fixed belt conveyor 6A, a film peeling guide member 6B, a moving belt conveyor 6C and a film discharging conveyor belt mechanism 6D.

The fixed belt conveyor 6A consists, as shown in Figs. 1, 6 and 7, of a plurality of pairs of rollers 6Aa, 6Aa′ and a belt 6Ab wound on each pair of rollers 6Aa, 6Aa′.

The moving belt conveyor 6C consists, as shown in Figs. 1, 6, of a plurality of pairs of rollers 6Ca, 6Ca′ and a belt 6Cb wound on each pair of rollers 6Ca, 6Ca′. The moving belt conveyor 6C is operated by an air cylinder 6Cc around the other roller 6Ca′ and caused tomove close to or touch the belt 6Ab of the fixed belt conveyor 6A or film peeling guide member 6B.

The fixed belt conveyor 6A and the moving belt conveyor 6C sandwich the translucent resin film 1D peeled off by the fluid spray mechanism 5 (in the position shown by a dotted line of Fig. 6) and driven by the pari of rollers 6Aa, 6Aa′ and that of rollers 6Ca, 6Ca′ so as to peel and discharge the translucent resin film 1D successively.

The film peeling guide member 6B is installed in the case of the film peeling apparatus on the fixed belt conveyor 6A side and arranged in the midposition of the belt 6Ab.

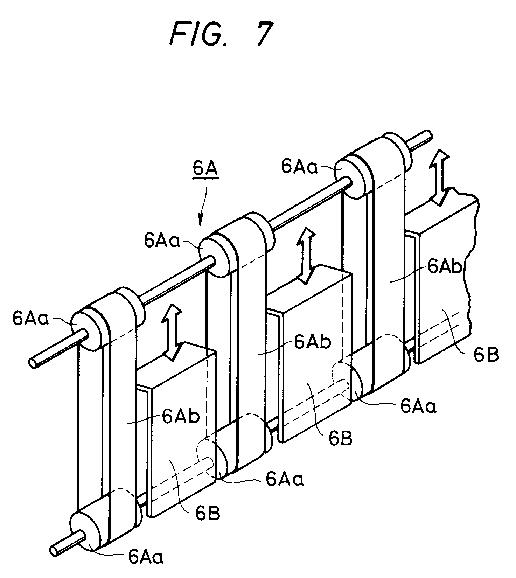

The film peeling guide member 6B is capable of preventing the fluctuation of the peel position and the distortion of the peel stress while the translucent resin film 1D is peeled off and used to lead the translucent resin film 1D peeled in such a manner as to set the peel angle (as viewed from the conveyance direction of the board 1) of the raised translucent resin film 1D obtuse with the printed circuit board 1 for the purpose of preventing damage and breakdown to the photosensitive resin layer 1C. The front end of the film peeling guide member 6B is installed apart from the printed circuit board 1 to the extent that the latter is not rubbed by the former. However, the peel angle ϑ of the film peeling guide member 6B may be arranged in the direction roughly perpendicular to the printed circuit board or made variable in angular and/or linear manner as indicated in Figs. 6 and 7.

The front end of the film peeling guide member 6B is in the form of an arc having a small curvature radius in cross section, e.g., a curvature radius of 3 mm or smaller.

The peel position is stabilized by thus installing the film peeling guide member 6B and uniform peel stress can be added to the translucent resin film 1D and the photosensitive resin layer 1C.

As set forth abovce, since the film conveyance means 6 is composed of the fixed belt conveyors 6A, the film peeling guide members 6B and the moving belt conveyors 6C, the translucent resin films 1D peeled off by the fluid spray mechanisms 5 are led by the film peeling guide members 6B, sandwiched by the fixed belt conveyors 6A and them oving belt conveyors 6C, conveyed while being peeled off and carried out in the discharge direction shown by an arrow OUT.

As shown in Fig. 1, the film discharging conveyor belt mechanism 6D consists of a plurality of rollers 6Da and a pair of belts 6Db and is so arranged as to discharge the translucent resin film 1D on the upper side of the printed circuit board 1.

The moving belt conveyor 6C may be moved by a solenoid or hydraulic cylinder instead of the air cylinder 6Cc.

Since the film discharge mechanism 6 is installed in the conveyance path of the printed circuit board 1, the translucent resin film 1D peeled off by the fluid spray mechanism 5 is certainly automatically discharged, so that workhours can be reduced by a large margin.

After the translucent resin films 1D are peeled off by the fluid spray mechanisms 5 and the film discharge mechanism 6, the printed circuit board 1 is carried by the conveyance control rollers 3 and the conveyor rollers 2 into a developing device for developing the photosensitive resin layers 1C.

The present invention is not restricted to the above application but may be modified in various manner without departing from the scope of the invention.

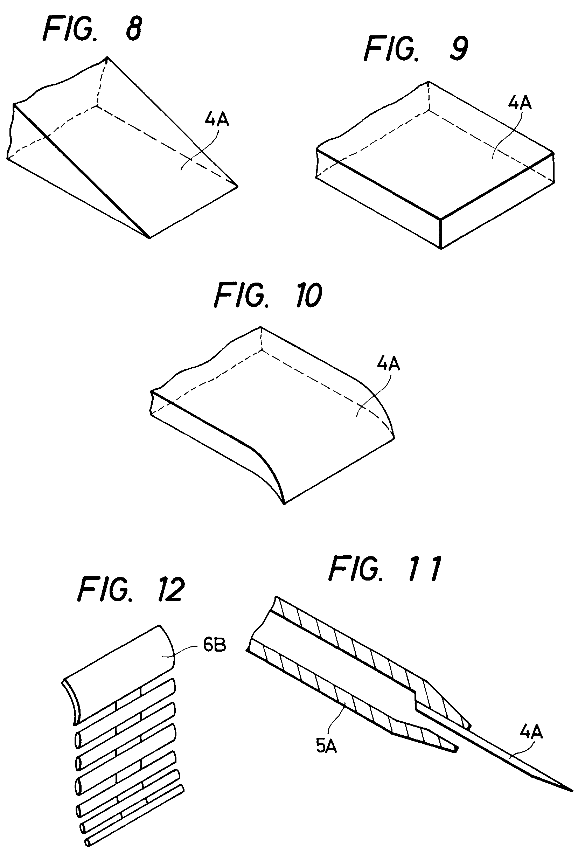

The projected press member 4A may be, e.g., arranged as shown in Figs. 8, 9 and 10. In other words, the projected press member 4A shown in Fig. 8 is wedge-shaped and what is shown in Fig. 9 is flat plate-shaped, whereas what is shown in Fig. 10 is curved wedge-shaped.

Moreover, the projected press member 4A may be, as shown in Fig. 11, incorporated in the front end of the nozzle 5A of the fluid spray mechanism 5 or made of another material. In this case, the translucent resin film 1D can be peeled off because the gap formed by applying force to the photosensitive resin layer 1C and the translucent resin film 1D coincides with the portion to which a jet of fluid is sent.

The film peeling guide member 6B may be formed into a grid with a plurality of barmembers as shown in Fig. 12. However, the front end member of the film peeling member 6B is in the form of an arc having a small curvature radius in cross section.

Moreover, the film discharge mechanism 6 may be formed with a combination of rotary rollers, another of fixed belts, a rotary roller used to wind the film or a sucking disk whose suction force is used to peel and convey the film.

The projected press member 4A may be installed not in the conveyance direction but the one perpendicular thereto.

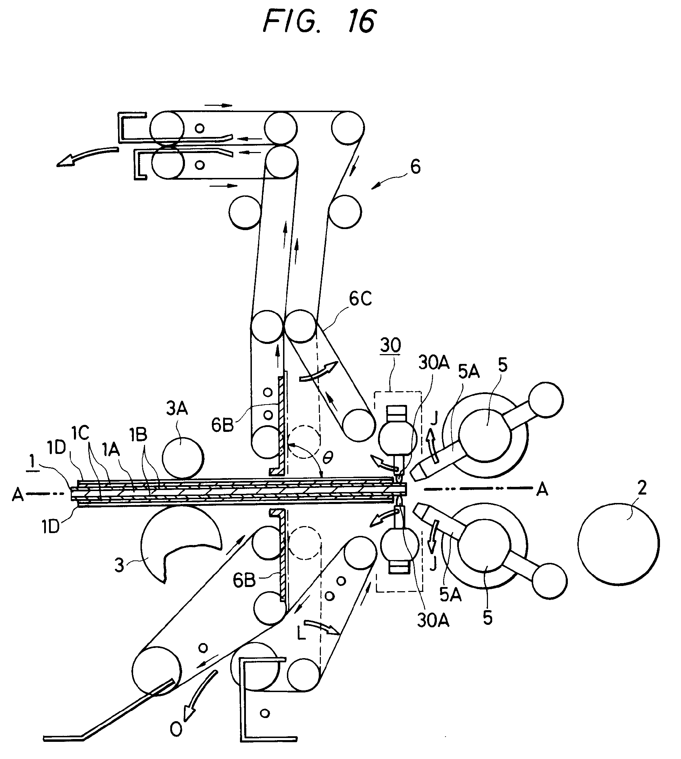

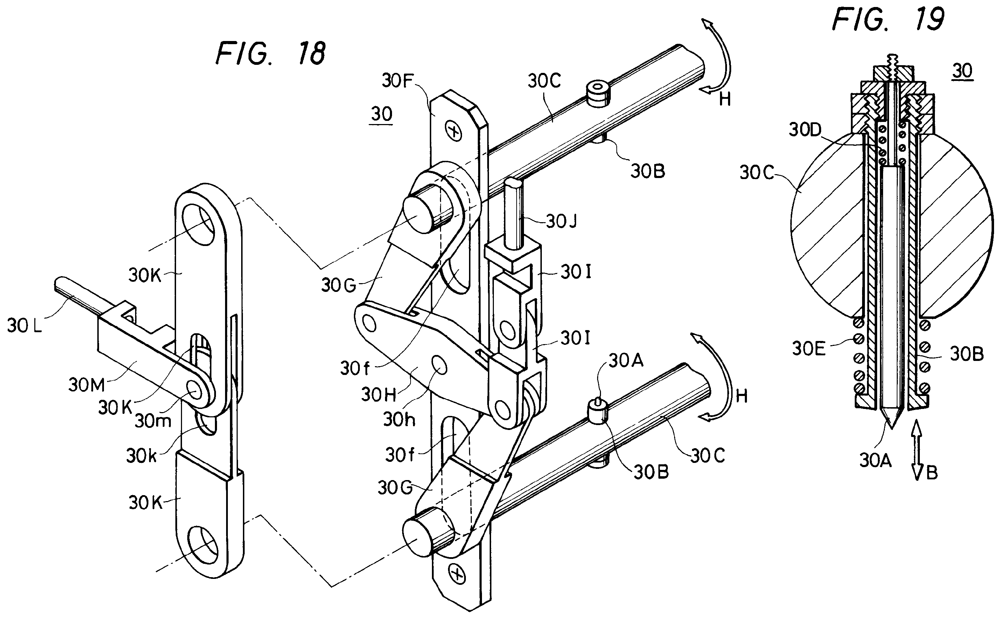

Figs. 16 to 21 show still another embodiment of the invention in which, instead of the film raising members 4, is used a projected press mechanism 30 which comprises a plurality of projected press members 30A installed on both sides of the prined circuit board 1, the projected press members 30A being arranged in the direction across the conveyance direction (the crosswise direction of the printed circuit board 1). Each projected press member 30A is needle-shaped as shown in Fig. 19 and formed so that the end of the laminated body composed of the photosensitive resin layer 1C and the translucent resin film 1D is pressed by the front end of the projected press member 30A. The projected press member 30A is also so arranged as not to bite into the interface between the conductive layer 1B and the photosensitive resin layer 1C when the projected press member 3A presses the end of the laminated body and have an apex angle of, e.g., about 60 degrees to make the translucent resin film 1D peel off the photosensitive resin layer 1C. Each of the projected press members 30A arranged opposite to each other is supported by a discrete projected press member supporting rotary shaft 30C through a holder 30B. The holder 30B, which is supplied with a code, is installed in such a manner as to slide along the through-hole of the projected press member supporting rotary shaft 30C.

The same or different elastic members 30C and 30E are installed between the projected pressmember 3A and the holder 3B and between the holder 30B and the projected press member supporting rotary shaft 30C, respectively. The elastic members 30D and 30E are installed in the direction of an arrow B, i.e., in such a manner as to act on the direction close to the printed circuit board 1. Accordingly, the position of the front end of the projected press member 30A can be changed by a given pressure in the direction of the arrow B relative to the projected press member supporting rotary shaft 30C.

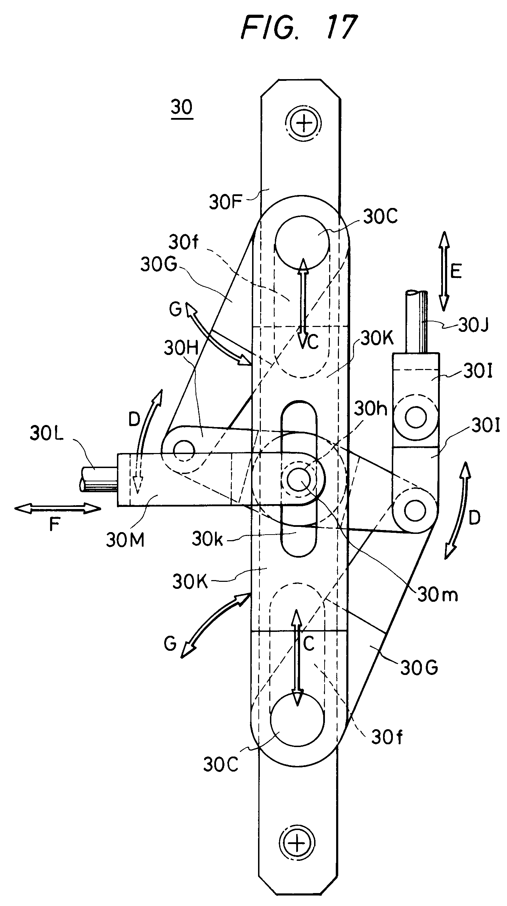

One end (or both ends) of the projected press member supporting rotary shaft 30C is, as shown in Figs. 17 and 18 rotatably coupled to one end of a moving arm member 30G through a guide slit 30f made in a guide member 30F. The guide member 30F is fixed to the apparatus body with machine screws and the like (not shown). The guide slit 30f is formed in the direction of an arrow C so as to guide the projected press member supporting rotary shaft 30C, i.e.,. the projected press member 30A.

The other end of each moving arm member 30G is rotatably secured to one of the opposite ends of a rotary arm member 30H secured rotatably on the rotary shaft 30h in the direction of an arrow D. The rotary arm member 30H is capable of moving each moving arm member 30G in the longitudinal direction of an arrow C.

The guide member 30F, the moving arm member 30G and the rotary arm member 30H for guiding the projected press member supporting rotary shaft 30C constitute the link mechanism of the projected press mechanism 30 for mutually nearing and departing the projected press member 30A installed on both sides of the printed circuit board 1 through the movement of the shaft 30J of the driving source for both surface use in the direction of an arrow E. The shaft 30J is coupled to one end of the rotary arm member 30H through an arm coupling member 30I. The members constituting the link mechanism each are prepared from material relatively hardly deformable against external force such as iron, aluminum alloy and rigid plastics. The driving power may be derived from a pneumatic or hydraulic cylinder, or a solenoid. The shaft 30J may be coupled to one end of the moving arm member 30G through the arm coupling member 30I but not limited to one end of the rotary arm member 30H.

By thus coupling the projected press member 30A to the driving source for both side use by means of the link mechanism, the projected press members 30A installed on both sides of the printed circuit board 1 each may be caused to contact or part from the surface of the printed circuit board 1 (movement in the direction of the arrow C). In other words, the link mechanism is capable of driving the both side projected press members 30A by means of the driving source for both side use without providing driving source for individually driving the projected press member 30A on both sides of the printed circuit board 1.

The guide member 30F, the moving arm members 30G and the rotary arm member 30H constituting the link mechanism are rigid bodies and the operating range of each is defined by the guide slit 30f and the rotary shaft 30h. In consequence, the projected press members 30A on both sides of the printed circuit board 1 can be controlled accurately and equally in terms of their operating quantity and time.

The link mechanism for coupling the projected press member 30a and the driving source for both side use can be made simpler in construction than what is formed with a rack and pinion or gear mechanism because the number of parts is smaller and each part is simpler in configuration.

At one end (or both ends) of each projected press member supporting rotary shaft 30C linked with the moving arm member 30G is installed a projected press member rotating arm member 30K whose one end is fixed. At the other end of each projected press member rotating arm member 30K is provided a slit 30k and the shaft 30m of the arm coupling member 30M connected to the shaft 30L of the driving source for both side use is passed through the slit 30k. In other words, the projected press member rotating arm member 30K is coupled to the shaft 30L of the driving source for both side use through the coupling arm member 30M. As the driving source for both side use, a link mechanism similar to what was mentioned above may be used.

The projected press member rotating arm member 30K and the arm coupling member 30M constitute the projected press member pressing mechanism of the projected press mechanism 30 for rotating the projected press member rotating arm member 30K in the direction of the arrow G as a shaft L moves in the direction of an arrow F, rotating the projected press member supporting rotary shaft 30C in the direction of an arrow H and pressing the end of the laminated body.

The projected press member pressing mechanism thus constructed is capable of operating the projected press members 30A on both sides of the printed circuit board 1 with one driving source as in the case of the link mechanism for the projected press members 30A and controlling the operating quantity and time thereof accurately.

Moreover, the projected press member pressing mechanism can simplify the coupling mechanism for coupling the projected press member 30A and the driving source.

Although the link mechanism or projected press member pressing mechanism and the driving source for both side use are installed on one side of the projected member supporting rotary shaft 30C, they may be installed on both sides according to the present invention.

Referring to Figs. 16 through 21, the operation of the projected press mechanism 30 will be described briefly.

A thin film end detector (not shown) is used first. As a thin film end detector, use can be made of a touch sensor for electrically detecting the end of a thin film laid on the printed circuit board 1 or a photosensor for detecting the same optically.

When the end of a laminated body (thin film) stuck onto the printed circuit board is detected by the thin film end detector, pinch roller 3A shown in Fig. 16 is pressed against the printed circuit board 1 using a press means (not shown) and the conveyance of the printed circuit board 1 is temporarily stopped by the press means and a conveyance driving roller 3. At this time, material such as rubber having a high coefficient of friction is attached to the outer peripheral surface of the conveyance driving roller 3 opposite to the pinch roller 3A to prevent the position of the printed circuit board from shifting and the printed circuit board 1 is fixed by securely stopping the conveyance of the printed circuit board 1.

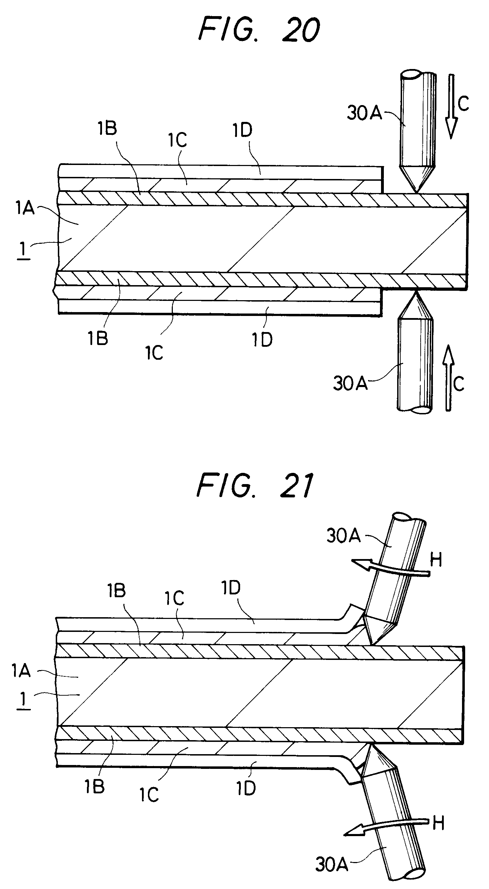

The shaft 30J of the driving source for both-side use coupled to the link mechanism is moved in the direction of an arrow E (upward in FIG. 17). This operation allows the link mechanism constituted by the rotary arm member 30H, the moving arm member 30G and the guide member 30F to operate and the projected press member supporting rotary shaft 30C is caused to move in the direction of the arrow C. As the projected press member supporting rotary shaft 30C moves, each of the front ends of the projected press members 30A on both sides of the printed circuit board 1 contacts the surface of the conductive layer 1B at the end of the laminated body as shown in Fig. 20. The contact is attained by the application of suitable force so that the elastic member 30D (30E) may have energy.

While the projected press member 30A is in contact with the conductive layer 1B, the shaft 30L of the driving source for both side use coupled to the projected press member pressing mechanism is operated (to the left in the drawing). This operation causes the projected press member pressing mechanism composed of the projected press member rotating arm member 30K and the arm coupling member 30M to operate and the projected press member supporting rotary shaft 30C is rotated in the direction of the arrow H. As the projected press member supporting rotary shaft 30C rotates, the front ends of the projected press members 30A on both sides of the printed circuit board 1 press the end of the laminated body.

By pressing the end of the laminated body composed of the photosensitive resin layer 1C and the translucent resin film 1D and stuck on the printed circuit board 1 with the projected press members 30A of the projected press mechanism 30, part of the translucent resin film 1D is peeled off the photosensitive plastic layer 1C, so that a gap can be produced in the interface. The gap is attributed to the fact that, because the photosensitive resin layer 1C is prepared from material softer than that for the translucent resin film 1D, the former is subjected to plastic deformation against the pressure applied by the projected press member 30A, whereas the adhesion of the latter to the former reduces before the latter is subjected to plastic deformation.

Moreover, the end of the translucent resin film 1D can be peeled off by the needle-shaped projected press member 30A simple in configuration.

Since the projected press member 30A is installed in the conveyance path of the printed circuit board, the end of the translucent resin film 1D can automatically be peeled off.

The translucent resin film 1D thus peeled off once never sticks to the photosensitive plastic layer 1C again unless it is heated and adhesion bonded under pressure.

A plurality of projected press members 30A are installed in the direction across (crosswise direction) the conveyance direction of the printed circuit board 1 according to this embodiment in consideration of the case where the laminated body may be heat bonded distortedly on the printed circuit board 1. However, the projected press mechanism 30 may also be so arranged as to provide the projected press members 30A each on both sides of the printed circuit board 1 as long as one end of the photosensitive resin layer 1C and the translucent resin film are pressed to ensure that the latter is peeled off.

Although the projected press members 30A are arranged in the direction (crosswise direction) across the conveyance direction of the printed circuit 1 according to this embodiment, the projected press members 30A may be installed at the end or any place close to the corner of the laminated body still in the same direction as the conveyance direction of the printed circuit board 1. In this case, the nozzle 5A of the fluid spray mechanism 40 is set close to the projected press member 30A.

The link mechanism according to this embodiment has been arranged in the form of the projected press member pressing mechanism of the projected press mechanism 30. However, the construction of the projected press member pressing mechanism according to the present invention may be so arranged as to carry the printed circuit board 1 slight by rotating the conveyance driving roller 3 (or the pinch roller 3A) in such a state that the projected press member 30A makes contact with the surface of the printed circuit board 1 at the end of the laminated body and to press the end of the laminated body.

Moreover, the cross section of the projected press member supporting rotary shaft 30C in the direction across the axis of the shaft according to the present invention may be square with the view of increasing the accuracy of processing the through-hole into which the holder 30B is fitted and facilitating the processing.

As shown in Fig. 16, the fluid spray mechanism 5 may be so arranged as to send a jet of pressurized fluid such as air, inactive gas or water out of the nozzle 5A directly to the gap between the photosensitive resin layer 1C and the peeled translucent resin film 1D. The fluid spray mechanism is also positioned close to the projected press mechanism 3 so that the fluid can instantly be sent to the gap. The fluid spray mechanism 5 is provided with the nozzle 5A whose set angle is variable in the direction of an arrow J. In other words, the fluid spray mechanism 5 sets its nozzle 5A as close to the above gap as possible at the time of spraying the fluid and moves the nozzle 5A back to the position where it is prevented from touching the printed circuit board 1.

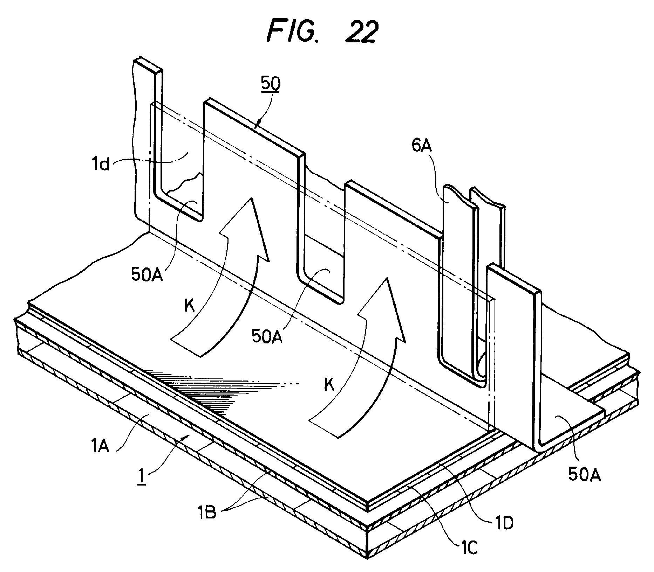

Since the fluid is blown into the gap between the photosensitive resin layer 1C and the translucent resin film 1D by means of the fluid spray mechanism 5 for sending a jet of fluid to the gap produced under the pressure of the projected press member 30A between the photosensitive resin layer 1C and the translucent resin film 1D, it is ensured to peel the translucent resin film 1D off the photosensitive resin layer 1C instantly. As shown in Figs. 16, 22 (perspective view of the principal portion), the front end 1d of the translucent resin film peeled off by the fluid spray mechanism 5 in the conveyance direction thereof adheres to the peel angle setting plate (auxiliary peeling plate) 50 under the fluid pressure, allowing the setting of the peel position, direction and angle ϑ. The translucent resin film 1d is shown by an alternate long and short dash line of Figs. 16, 22. The peel angle ϑ is the one made between the translucent resin film stuck onto the printed circuit board 1 (or the printed circuit board 1 from which the translucent resin film 1D has been peeled) and the translucent resin film 1d pulled up, both of the layer and the film being at roughly right angles.

The peel angle setting plate 50 at the front end (peel position) on the peeling side is installed apart from the translucent resin film 1D stuck on the printed circuit board 1 to the extent that the setting plate may not brush the resin film 1D to prevent damage to and breakdown of the photosensitive resin layer 1C. The front end of peel angle setting plate 50 is movably arranged so as to tightly stick to the translucent resin film 1D during the fluid spray and prevent reduction in the peel effect because the fluid is blown through. Moreover, the front end of the peel angle setting plate 50 is arcuate with a small curvature radius, e.g., a curvature radius of less than 3 mm.

Moreover, the peel angle setting plate 50 has its front end located closer to the printed circuit board 1 than to the thin film delivery mechanism 6 and a predetermined length equivalent to the length covering the whole range of the width of the conveyance path of the printed circuit board 1 or the fluid spray width in the peel direction. In other words, the peel angle setting plate 50, as the direction of the fluid flow is shown by an arrow K of Fig. 22, is capable of increasing the peeling effects by preventing the fluid from being blown to the rear side to the utmost and the adhesion of the peeled translucent resin film 1d to the peel angle setting plate 50.

The peel angle setting plate 50 is fixed to the predetermined position of the apparatus body apart from the nozzle 5A in the direction of the fluid flow.

The peel angle setting plate 50 is able to stabilize the peel position and add uniform peeling force to the translucent resin film 1D. Accordingly, the peel angle setting plate 50 contributes to preventing the peel position from shifting while the translucent resin film 1D is being peeled off and peel stress from distorting and the photosensitive resin layer 1C from being damaged or broken.

The peel angle ϑ of the peel angle setting plate 5 may be set variable within the range of obtuse to right angle with the translucent resin film 1D according to changes in conditions, e.g., material for the translucent resin film 1D, the fluid pressure in the fluid spray mechanism 5, etc. Moreover, the peel angle setting plate 50 may be made movable to deal with the printed circuit boards 1 different in thickness, the photosensitive resin layers 1C as well as the translucent resin films 1D different in thickness. The transfer thereof can be made by an air or hydraulic cylinder.

The translucent resin film 1d stuck to the peel angle setting plate 50 by the fluid spray mechanism 5 is, as shown in Fig. 16 (an expanded exploded perspective view), sent out by the thin film carrying out mechanism (thin film conveyance mechanism) 6 while the thin film is being peeled off.

Although a description has been given of the peeling apparatus of the present invention for peeling off the films on the printed circuit board, it is applicable to peeling off a protective film covering a decorative laminated sheet used as construction material.

As set forth above, the following effects are achievable:
(1) A gap is formed between the film and the underside thereof by applying force to the end of the film with the projected press member and a jet of fluid is sent by the fluid spray means to the gap, whereby the film can instantly be peeled off with a simple arrangement of component parts.
(2) Because of (1), the film peeling time can be shortened.
(3) Since the film discharging means is provided so as to carry out the film peeled off by the fluid spray means of (1), the film peeling work can be carried out automatically and the film peeling time can thus be shortened.
(4) The film peeling guide member is installed so as to set the peel direction of the film peeled off by the fluid spray means of (3), so that the peel position is stabilized by applying uniform peel stress to the film such as the photosensitive resin layer and the translucent resin film. Consequently, the fluctuation of the peel position and the distortion of the peel stress while a film such as the translucent resin film is peeled off are prevented and the photosensitive resin layer is automatically peeled off without damaging and breaking it.
(5) The projected press member is installed close to the portion to which a jet of fluidis sent by the fluid spray means of (1) to ensure that the film is peeled off, because the position where the gap is formed under the film by applying force thereto always coincides with the position to which the fluid is sent.

## Claims

1. A film peeling apparatus for peeling off a film (1D) stuck on a board (1), comprising a press member (4, 30) installed in the conveyance path of the board (1) for applying force to the leading end of the film (1D) on the board (1), to form a gap (E) between the film (1D) and the board (1) and further comprising fluid spray means (5, 5A) for sending jets of fluid into said gap for thereby peeling the leading end of the film (1D) off the board (1) and adhering it to at least one film peeling guide member (6B) of a film discharge mechanism (5) installed in the conveyance path of the board (1), the film peeling guide member (6B) setting the peeling direction of the film (1D) from the board (1) and guiding the film peeled from the board (1), the mechanism further being provided with belt conveyors sandwiching and carrying away the film (1D) peeled off, the film peeling guide member (6B) being arranged in relation to the conveyance path of the board (1) in such a way, that the front end of the film peeling guide member (6B) is spaced from the board (1) to the extent that the board (1) is not rubbed by the film peeling guide member (6B), the latter further being arranged in relation to the fluid spray means (5, 5A) in such a way that the jets sent from the fluid spray means (5, 5A) are prevented from passing over the film (1D) to the rear.

2. A film peeling apparatus according to claim 1,
characterised in
that the guide member(6B) is linearly movable in a direction to and from the surface of the board (1).

3. A film peeling apparatus according to any of the preceeding claims,
characterised in
that the front end of the guide member(6B) is in the form of an arc having a small curvature radius in cross section.

4. A film peeling apparatus according to claim 3,
characterised in
that the curvature radius is 3 mm or smaller.

5. A film peeling apparatus according to claims 3 or 4,
characterised in
that the guide member (6B) is formed into a grid with a plurality of barmembers.

6. A film peeling apparatus according to any of the preceeding claims,
characterised in that
the spray means (5, 5A) comprises at least one nozzle (5A) for sending jets of pressurized air, inert gas or water.

7. A film peeling apparatus according to claim 6, charaterised in that
the nozzle (5A) is angularly movable.

8. A film peeling apparatus according to claim 6 or 7,
characterized in that
the press member (4A) is incorporated in the front end of the nozzle (5A).

9. A film peeling apparatus according to any of the preceeding claims,
characterised in that
the press member (4A) is wedge-shaped, flat plate-shaped or curved wedge-shaped.

## Patentansprüche

1. Vorrichtung zum Abschälen von auf einer Platte (1) haftenden Filmen (1D), mit einem Druckteil (4, 30), angeordnet in dem Förderweg der Platte (1) zum Ausüben von Kraft auf das vordere Ende des auf der Platte (1) haftenden Films (1D), um einen Spalt (E) zwischen dem Film (1D) und der Platte (1) zu bilden, einer Flüssigkeitsspritzeinrichtung (5, 5A) zum Abgeben von Flüssigkeitsstrahlen in den Spalt, um dadurch das vordere Ende des Films (1D) von der Platte (1) abzuschälen und es an wenigstens ein Filmabschäl-Führungsteil (6B) eines Filmabgabemechanismus zu haften, der in dem Förderweg der Platte (1) angeordnet ist, wobei das Filmabschäl-Führungsteil (6B) die Abschälrichtung des Films (1D) von der Platte (1) einstellt und den von der Platte (1) abgeschälten Film führt, wobei der Mechanismus desweiteren versehen ist mit Förderbändern, die den abgeschälten Film (1D) sandwichartig umgeben und fortführen, wobei das Filmabschäl-Führungsteil (6B) derart bezüglich dem Förderweg der Platte (1) angeordnet ist, daß das vordere Ende des Filmabschäl-Führungsteils (6B) von der Platte (1) so weit entfernt ist, daß die Platte (1) nicht von dem Filmabschäl-Führungsteil (6B) gerieben wird, und das Filmabschäl-Führungsteil (6B) derart bezüglich der Flüssigkeitsspritzeinrichtung (5, 5A) angordnet ist, daß verhindert wird, daß die von der Flüssigkeitsspritzeinrichtung (5, 5A) abgegebenen Strahlen nach hinten über den Film (1D) gelangen.

2. Vorrichtung nach Anspruch 1, dadurch **gekennzeichnet**, daß das Führungsteil (6B) in einer Richtung zur Oberfläche der Platte hin und von ihr fort linear bewegbar ist.

3. Vorrichtung nach einem der vorhergehenden Ansprüche, dadurch **gekennzeichnet**, daß das vordere Ende des Führungsteils (6B) die Form eines Bogens aufweist, dessen Querschnitt einen kleinen Krümmungsradius aufweist.

4. Vorrichtung nach Anspruch 3, dadurch **gekennzeichnet**, daß der Krümmungsradius 3 mm oder kleiner ist.

5. Vorrichtung nach Anspruch 3 oder 4, dadurch **gekennzeichnet**, daß das Führungsteil (6B) zu einem Gitter mit einer Mehrzahl von Stäben ausgebildet ist.

6. Vorrichtung nach einem der vorhergehenden Ansprüche, dadurch **gekennzeichnet,** daß die Spritzeinrichtung (5, 5A) wenigstens eine Düse (5A) zum Aussenden von Druckluftstrahlen, Strahlen eines inerten Gases oder Wasserstrahlen aufweist.

7. Vorrichtung nach Anspruch 6, dadurch **gekennzeichnet**, daß die Düse (5A) im Winkel verstellbar ist.

8. Vorrichtung nach Anspruch 6 oder 7, dadurch **gekennzeichnet**, daß das Druckteil (4A) in dem vorderen Ende der Düse (5A) untergebracht ist.

9. Vorrichtung nach einem der vorhergehenden Ansprüche, dadurch **gekennzeichnet**, daß das Druckteil (4A) keilförmig, flachplattig oder in Form eines gebogenen Keils ausgebildet ist.

## Revendications

1. Appareil de pelage de film (1D), permettant de peler un film (1D) adhérant sur une plaquette (1), comprenant un organe de pression (4, 30) monté sur la trajectoire de transport de la plaquette (1) et servant à appliquer une force sur l'extrémité amont du film (1D), situé sur la plaquette (1), pour former un intervalle (E) entre le film (1D) et la plaquette (1), et comprenant en outre des moyens de pulvérisation de fluide (5, 5A) servant à projeter des jets de fluide dans ledit intervalle, afin de peler de ce fait l'extrémité amont du film (1D) en la séparant de la plaquette (1), et à faire adhérer cette extrémité sur au moins un organe de guidage de pelage de film (6B) d'un mécanisme d'évacuation de film (5) monté sur la trajectoire de transport de la plaquette (1), l'organe de guidage de pelage de film (6B) servant à déterminer la direction de pelage du film (1D) à l'écart de la plaquette (1) et à guider le film (1D) pelé à l'écart de la plaquette (1), le mécanisme étant en outre pourvu de bandes transporteuses servant à prendre en sandwich le film (1D) pelé et à le transporter à l'écart, l'organe de guidage de pelage de film (6B) étant disposé vis-à-vis de la trajectoire de transport de la plaquette (1) d'une manière telle que l'extrémité avant de l'organe de guidage de pelage de film (6B) est espacée de la plaquette (1) d'une distance telle que l'organe de guidage de pelage de film (6B) ne frotte pas sur la plaquette (1), cet organe de guidage de pelage de film (6B) étant en outre agencé vis-à-vis des moyens de pulvérisation de fluide (5, 5A), d'une manière telle que les jets projetés par ces moyens de pulvérisation de fluide (5, 5A) sont empêchés de passer par dessus le film (1D) vers l'arrière.

2. Appareil de pelage de film selon la revendication 1, caractérisé en ce que l'organe de guidage (6B) est agencé de façon à pouvoir être animé d'un mouvement rectiligne vers la surface de la plaquette (1) et à partir de cette plaquette (1).

3. Appareil de pelage de film selon l'une quelconque des revendications précédentes, caractérisé en ce que l'extrémité avant de l'organe de guidage (6B) se présente sous la forme d'un arc ayant un petit rayon de courbure en section transversale.

4. Appareil de pelage de film selon la revendication 3, caractérisé en ce que le rayon de courbure est égal ou inférieur à 3 mm.

5. Appareil de pelage de film selon l'une des revendications 3 et 4, caractérisé en ce que l'organe de guidage (6B) a la forme d'une grille comportant plusieurs éléments en forme de barre.

6. Appareil de pelage de film selon l'une quelconque des revendication précédentes, caractérisé en ce que les moyens de pulvérisation(5, 5A) comprennent au moins une buse (5A) servant à projeter des jets d'air comprimé, de gaz inerte ou d'eau.

7. Appareil de pelage de film selon la revendication 6, caractérisé en ce que la buse (5A) est agencée de façon à pouvoir être animée d'un mouvement angulaire.

8. Appareil de pelage de film selon l'une des revendications 6 et 7, caractérisé en ce que l'organe de pression (4A) fait partie de l'extrémité avant de la buse (5A).

9. Appareil de pelage de film selon l'une quelconque des revendications précédentes, caractérisé en ce que l'organe de pression (4A) est en forme de coin, en forme de plaque plane ou en forme de coin à surface courbe.
